# EUROPÄISCHE PATENTSCHRIFT

(11) **EP 3 264 115 B1**
(45) Veröffentlichungstag und Bekanntmachung des Hinweises auf die Patenterteilung: **10.03.2021**
(21) Anmeldenummer: 17174062.4
(22) Anmeldetag: 01.06.2017
(51) Int. Cl.: G01R 31/08, F16L 57/00, H01B 7/14, H02G 9/00

(54) **VERFAHREN ZUM BESTIMMEN EINES ISOLATIONSFEHLERORTES AUF EINEM ELEKTRISCHEN LEITER EINER UNTERMEERESVERSORGUNGSLEITUNG**
METHOD FOR DETERMINING AN ISOLATION FAULT LOCATION ON AN ELECTRICAL CONDUCTOR OF A SUBMARINE SUPPLY CONDUIT
PROCÉDÉ DE DÉTERMINATION D'UN EMPLACEMENT DE DÉFAUT D'ISOLATION DANS UN CONDUCTEUR ÉLECTRIQUE D'UNE LIGNE D'ALIMENTATION IMMERGÉE

(30) Priorität: 28.06.2016 DE 102016211651
(43) Veröffentlichungstag der Anmeldung: 03.01.2018
(73) Patentinhaber: Bender GmbH & Co. KG, 35305 Grünberg (DE)
(72) Erfinder: HACKL, Dieter, 35463 Fernwald (DE)
(74) Vertreter: advotec.

(56) Entgegenhaltungen:
- WO-A2-2011/052890
- JP-A- S5 842 979
- JP-A- S5 842 980
- US-A1- 2010 280 773
- US-A1- 2014 283 585

## Beschreibung

Die Erfindung betrifft Verfahren und Ortungssysteme zum Bestimmen eines Isolationsfehlerortes auf einem elektrischen Leiter einer Untermeeresversorgungsleitung.

In der Tiefseeförderung von Öl und Gas werden die Förderfelder auf dem Meeresgrund von einer zentralen Förderplattform ausgehend über verzweigte Untermeeresversorgungsleitungen, sogenannte Umbilicals, mit elektrischer Energie, Druckleitungen und Steuerinformation versorgt. Die Ausdehnung der Förderfelder ist so groß, dass einzelne Untermeeresversorgungsleitungen bis zu 150 km Länge erreichen können.

Der Ausfall einer Untermeeresversorgungsleitung kann nicht nur zu erheblichen wirtschaftlichen Einbußen durch Förderausfälle führen, sondern durch unkontrollierbar gewordene Fördereinrichtungen können auch große Gefahren für die Umwelt, die Förderanlage und das Betriebspersonal entstehen.

Die Erkennung und die schnelle Lokalisierung von Beschädigungen auf der Untermeeresversorgungsleitung, insbesondere von Isolationsfehlern auf einer in der Untermeeresversorgungsleitung mitgeführten elektrischen Leitung, haben daher gerade in diesem Anwendungsbereich von Versorgungsleitungen eine besonders hohe Priorität.

Die zur Lösung dieser sicherheitstechnischen Aufgaben verfügbare Technik ist jedoch durch die besonderen Anforderungen, die die Tiefseeumgebung stellt, begrenzt. Hierdurch erklärt sich der Umstand, dass die Lokalisierung von Isolationsfehlern auf in der Untermeeresversorgungsleitung mitgeführten elektrischen Leitungen meistens manuell mit dem Einsatz von Tauchern, Kleinunterseebooten und Schiffen erfolgt. Der Aufwand und damit die Kosten der Fehlerlokalisierung sind dementsprechend hoch.

Aus dem Stand der Technik sind Verfahren der Zeitbereichsreflektometrie (TDR) bekannt, um Fehlerorte auf einer elektrischen Leitung mittels reflektierten Messsignalen zu lokalisieren. Der Einsatz der TDR-Technologie erscheint jedoch mit der derzeit verfügbaren Technik beschränkt auf Leitungsabschnitte bis zu einer Länge von maximal 50 km.

Aufbauend auf der Erkenntnis, dass es bei einer im Meerwasser verlegten elektrischen Leitung an einer defekten Isolationsstelle zwischen dem freigelegten metallischen Leitermaterial, beispielsweise Kupfer, und dem salzhaltigen Meerwasser unter Einfluss einer anliegenden Gleichspannung zu Elektrolysevorgängen kommt, ist in der Patent-Offenlegungsschrift WO 2014/128439 A1 ein Regenerations-Verfahren vorgestellt worden, das die elektrochemische Reaktion nutzt, um Isolationsfehlerstellen zu heilen. Durch periodische Variation der Amplitude der Gleichspannung und einer optionalen Änderung der Polarität kann bei der Elektrolyse der Vorgang der Gasentstehung an der fehlerhaften Stelle so beeinflusst werden, dass eine Wiederherstellung der Isolationseigenschaften eintritt. Eine zielgerichtete Ortung der Isolationsfehlerstelle ist nicht offenbart.

Weitere relevante Dokumente aus dem Stand der Technik sind WO 2011/052890 A2 sowie JP S58 42980 A.

Der vorliegenden Erfindung liegt somit die Aufgabe zugrunde, ein Verfahren und ein Ortungssystem vorzuschlagen, mit denen ein Isolationsfehlerort auf einem elektrischen Leiter einer Untermeeresversorgungsleitung zuverlässig und wirtschaftlich vertretbar bestimmt werden kann.

Diese Aufgabe wird für eine Untermeeresversorgungsleitung, welche mit Meerwasser befüllbar ist, gelöst durch ein erstes Verfahren gemäß dem unabhängigen Anspruch 1.

In dem Stand der Technik bislang nicht genutzte Effekte bei der elektrochemischen Reaktion zwischen dem metallischen Leitermaterial und dem salzhaltigen Meerwasser sind die mit der Gaserzeugung einhergehende Bildung von Gasblasen in dem den Isolationsfehlerort umgebenden Meerwasser und die Betrachtung der mit der Ausbildung von Gasblasen verbundenen Geräuschentwicklung.

Der Grundgedanke des erfindungsgemäßen ersten Verfahrens beruht somit darauf, dass die Ausbildung der Gasblasen mit Geräuschen verbunden ist und die daraus resultierenden Schallwellen in einer mit Meerwasser befüllten Untermeeresversorgungsleitung mit Schallsensoren erfassbar sind. Diese erste Lösung geht davon aus, dass die Untermeeresversorgungsleitung mit Meerwasser befüllt ist, um den Auftrieb zu verringern und die Verlegung einfacher zu gestalten. Infolge der elektrochemische Reaktion mit der Gaserzeugung wirkt die daraus folgende Ausbildung von Gasblasen an dem Isolationsfehlerort als Schallquelle, deren abgestrahlte Schallwellen sich in der Meerwasserfüllung gerichtet ausbreiten und die mit Schallsensoren erfasst werden.

Dadurch, dass die elektrische Spannung aus einer modulierten Spannungs-Impulsfolge gebildet wird, findet eine zeitliche Änderung der angelegten Spannung statt, die sich in den erfassten Schallwellen - und in den erfassten Gasblasenmustern, siehe drittes Verfahren - abbildet. Durch Änderung eines Modulationsparameters wie Amplitude, Frequenz oder Phase, bzw. durch unterschiedliche Modulationsverfahren, werden der Elektrolysevorgang und damit die Gasblasenentwicklung so beeinflusst, dass sich die resultierenden Geräusch- und Gasblasenmuster deutlich von anderen möglichen Geräuschen und Gasblasenausbildungen unterscheiden.

An bekannten, festgelegten Orten entlang der Untermeeresversorgungsleitung sind Schallsensoren installiert, die die Schallwellen aufnehmen und in Messsignal-Impulsfolgen wandeln. Diese Messsignal-Impulsfolgen werden in Kenntnis der Sensororte und mit Einbeziehung der Schallausbreitungsgeschwindigkeit durch Laufzeitmessung zwischen Geräuschentstehung - hier als zeitgleich mit dem Anlegen der elektrischen Spannung angenommen - und Geräuscherfassung zur Bestimmung des Isolationsfehlerortes rechnerisch ausgewertet.

In einer vorteilhaften Ausgestaltung erfolgt die Auswertung der Messsignal-Impulsfolgen durch Korrelationsberechnungen der angelegten Spannungs-Impulsfolge mit den gemessenen Messsignal-Impulsfolgen.

Die als modulierte Spannungs-Impulsfolge erzeugte elektrische Spannung weist einen charakteristischen zeitlichen Verlauf auf, der sich in dem zeitlichen und räumlichen Verlauf der Schallwellen widerspiegelt.

Die von den Schallsensoren erzeugten Messsignal-Impulsfolgen zeigen daher ebenfalls einen charakteristischen zeitlichen Verlauf, sodass die empfangenen Schallsignale durch Korrelationsberechnungen der angelegten Spannungs-Impulsfolge mit den gemessenen Messsignal-Impulsfolgen identifizierbar sind.

Für eine Untermeeresversorgungsleitung, welche mit Meerwasser befüllbar ist, wird die Aufgabe mit einem zweiten Verfahren gemäß dem unabhängigen Anspruch 3 gelöst.

Diese zweite Lösung beruht ebenfalls auf dem für eine Schallausbreitung ursächlichen Effekt, nämlich der durch eine modulierte elektrische Spannung bewirkten elektrochemischen Reaktion zwischen dem metallischen Leitermaterial und dem salzhaltigen Meerwasser, welches den elektrischen Leiter in der mit Meerwasser befüllten Untermeeresversorgungsleitung unmittelbar umgibt. Die daraus resultierende Gasblasenbildung wiederum ist die Ursache für die Entstehung der Schallwellen in dem den elektrischen Leiter umgebenden Meerwasser.

Allerdings wird bei diesem zweiten Verfahren nicht die gerichtete Ausbreitung der Schallwellen innerhalb der Meerwasserfüllung der Untermeeresversorgungsleitung betrachtet, sondern es wird davon ausgegangen, dass die Schallwellen sich weitgehend ungerichtet auch außerhalb der Untermeeresversorgungsleitung im Meerwasser ausbreiten. Dort werden sie mit Schallsensoren erfasst, die an bekannten, festgelegten Orten installiert sind. Insbesondere bei Untermeeresversorgungsleitungen, die mit Durchbohrungen - Perforationen zur Flutung mit Meerwasser - versehen sind, breiten sich die Schallwellen nicht nur mittelbar über Schwingungen der äußeren Ummantelung der Untermeeresversorgungsleitung aus, sondern treten auch direkt durch die Durchbohrungen der äußeren Ummantelung aus.

Die von den Schallsensoren erzeugten Messsignal-Impulsfolgen werden analog zu dem ersten Verfahren in Kenntnis der Sensororte und mit Einbeziehung der Schallausbreitungsgeschwindigkeit durch Laufzeitmessung zwischen Geräuschentstehung und Geräuscherfassung zur Bestimmung des Isolationsfehlerortes rechnerisch ausgewertet.

In einer Ausgestaltung des Verfahrens erfolgt ebenfalls in Analogie zu dem ersten Verfahren die Auswertung der Messsignal-Impulsfolgen durch Korrelationsberechnungen der angelegten Spannungs-Impulsfolge mit den gemessenen Messsignal-Impulsfolgen.

Für eine Untermeeresversorgungsleitung, welche eine äußere Ummantelung mit Durchbohrungen aufweist, wird die Aufgabe mit einem dritten Verfahren gemäß dem unabhängigen Anspruch 5 gelöst.

Auch bei diesem dritten Verfahren bildet die durch eine modulierte elektrische Spannung bewirkte elektrochemische Reaktion zwischen dem metallischen Leitermaterial und dem salzhaltigen Meerwasser und die daraus resultierende Gasblasenbildung den Ausgangspunkt.

Allerdings liefert bei diesem dritten Verfahren nicht die Schallerfassung, sondern die optische Erfassung der durch die Durchbohrungen der äußeren Ummantelung austretenden Gasblasen eine Aussage über einen möglichen Isolationsfehlerort.

Hierzu wird die unmittelbare Umgebung entlang der Untermeeresversorgungsleitung mit einem beweglichen Bilderfassungssystem abgetastet.

Die erfassten Bildmuster werden im Hinblick auf eine Übereinstimmung mit typischen, durch die modulierte Spannungs-Impulsfolge eingeprägten Gasblasen-Bildmustern ausgewertet.

In Kenntnis des Erfassungsortes kann bei einer festgestellten Übereinstimmung der Isolationsfehlerort bestimmt werden.

Mit Vorteil erfolgen die Auswertung der Bildmuster und die Erkennung der Gasblasen-Bildmuster durch Korrelationsberechnungen der angelegten Spannungs-Impulsfolge mit einem erfassten Gasblasen-Bildmuster.

Infolge der durch die die modulierte Spannungs-Impulsfolge eingeprägten charakteristischen Gasblasenmuster lassen sich diese unter den erfassten Gasblasen durch Korrelationsberechnungen in zuverlässiger Weise identifizieren.

Die der Erfindung zugrundeliegende Aufgabe wird weiterhin durch jeweils ein Ortungssystem erfüllt, das einem der erfindungsgemäßen Verfahren entspricht.

Ein das erste Verfahren zum Bestimmen eines Isolationsfehlerortes auf einem elektrischen Leiter einer Untermeeresversorgungsleitung, welche mit Meerwasser befüllbar ist, ausführendes erstes Ortungssystem wird im unabhängigen Anspruch 7 definiert.

Ein das zweite Verfahren zum Bestimmen eines Isolationsfehlerortes auf einem elektrischen Leiter einer Untermeeresversorgungsleitung, welche mit Meerwasser befüllbar ist, ausführendes zweites Ortungssystem wird im unabhängigen Anspruch 8 definiert.

Ein das dritte Verfahren zum Bestimmen eines Isolationsfehlerortes auf einem elektrischen Leiter einer Untermeeresversorgungsleitung, welche eine äußere Ummantelung mit Durchbohrungen aufweist, ausführendes drittes Ortungssystem wird im unabhängigen Anspruch 9 definiert.

In weiterer Ausgestaltung sind das Bilderfassungssystem und die Bildauswerteeinrichtung als integriertes, autonom navigierendes Bildverarbeitungssystem ausgeführt.

Ein derartiges Bildverarbeitungssystem kann autonom die Untermeeresversorgungsleitung optisch abtasten (scannen) und in einem Fehlerfall, d.h. bei Erkennung eines erwarteten Gasblasen-Bildmusters, die Position des Isolationsfehlerortes kommunizieren.

Weitere vorteilhafte Ausgestaltungsmerkmale der Erfindung ergeben sich aus der nachfolgenden Beschreibung und den Zeichnungen, die bevorzugte Ausführungsformen der Erfindung an Hand von Beispielen erläutern. Es zeigen:
- **Fig. 1:**: eine schematische Übersichtsdarstellung zum Einsatzbereich der Erfindung,
- **Fig. 2:**: eine schematische Darstellung des ersten erfindungsgemäßen Ortungssystems,
- **Fig. 3:**: eine schematische Darstellung des zweiten erfindungsgemäßen Ortungssystems und
- **Fig. 4:**: eine schematische Darstellung des dritten erfindungsgemäßen Ortungssystems.

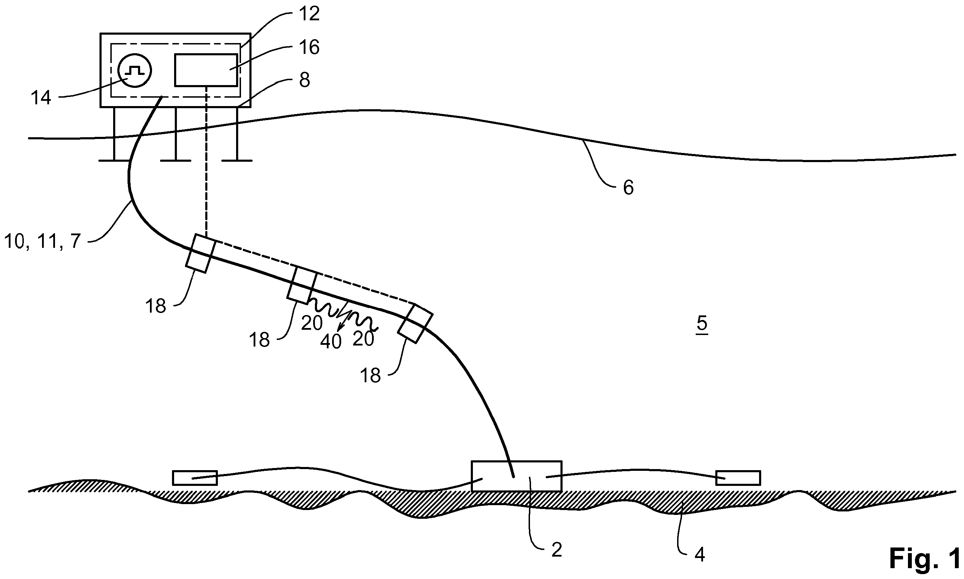

**Fig. 1** zeigt in einer schematischen Übersichtsdarstellung den Einsatzbereich der Erfindung. Ein Aggregat 2 eines Förderfeldes auf dem Meeresgrund 4 wird von einer an der Meeresoberfläche 6 befindlichen zentralen Förderplattform 8 ausgehend über eine Untermeeresversorgungsleitung 10 mit elektrischer Energie, Druckleitungen und Steuerinformation versorgt. Zur Stromversorgung weist die Untermeeresversorgungsleitung 10 einen elektrischen Leiter 11 auf.

In der Übersicht nach Fig. 1 ist beispielhaft ein auf dem ersten Verfahren beruhendes erstes Ortungssystem 12 gezeigt, welches von einer mit Meerwasser 5 umgebenen und mit einer Meerwasserfüllung 7 gefluteten Untermeeresversorgungsleitung 10 ausgeht.

Auf der Förderplattform 8 sind ein Spannungsgenerator 14 und eine Auswerteeinrichtung 16 des ersten Ortungssystems 12 angeordnet. Mit der Auswerteeinrichtung 16 sind Schallsensoren 18 verbunden, die an festgelegten Orten entlang der Untermeeresversorgungsleitung 10 installiert sind. Diese Schallsensoren 18 erfassen Schallwellen 20, die sich in dieser Darstellung (erstes Verfahren bzw. erstes Ortungssystem 12) ausgehend von einem Isolationsfehlerort 40 auf dem elektrischen Leiter 11 innerhalb der Untermeeresversorgungsleitung 10 in der Meerwasserfüllung 7 gerichtet ausbreiten.

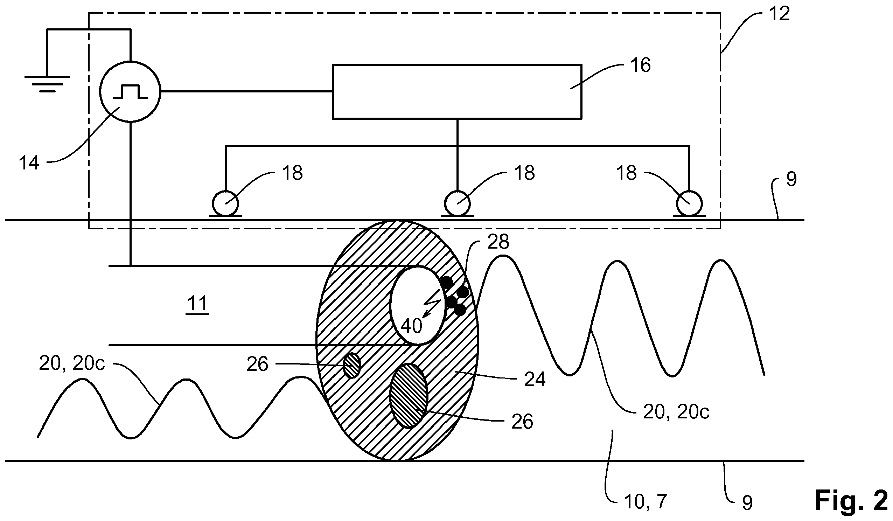

**Fig. 2** ist eine schematische Darstellung des ersten erfindungsgemäßen Ortungssystems 12.

Das Ortungssystem 12 umfasst den Spannungsgenerator 14 zur Erzeugung einer elektrischen Spannung gegen Erde, mit der der elektrische Leiter 11 der Untermeeresversorgungsleitung 10 beaufschlagt ist, sowie die Auswerteeinrichtung 16 und die außerhalb der Förderplattform 8 angeordneten Schallsensoren 18.

Im Querschnitt 24 gezeigt ist die mit einer Meerwasserfüllung 7 geflutete Untermeeresversorgungsleitung 10, in der - neben zwei weiteren Leitungen 26 - der elektrische Leiter 11 dargestellt ist, auf dem ein Isolationsfehler 40 aufgetreten ist.

Von dem Isolationsfehlerort 40 breiten sich infolge der Gasblasenbildung 28 in der Meerwasserfüllung 7 der Untermeeresversorgungsleitung 10 Schallwellen 20, 20c gerichtet aus. Diese Schallwellen 20, 20c werden von Schallsensoren 18 erfasst, die entlang der Untermeeresversorgungsleitung 10 unmittelbar an einer äußeren Ummantelung 9 der Untermeeresversorgungsleitung 10 installiert sind. Von den Schallsensoren 18 gelieferte Messsignal-Impulsfolgen werden zur Bestimmung des Isolationsfehlerortes 40 an die Auswerteeinrichtung 16 weitergeleitet.

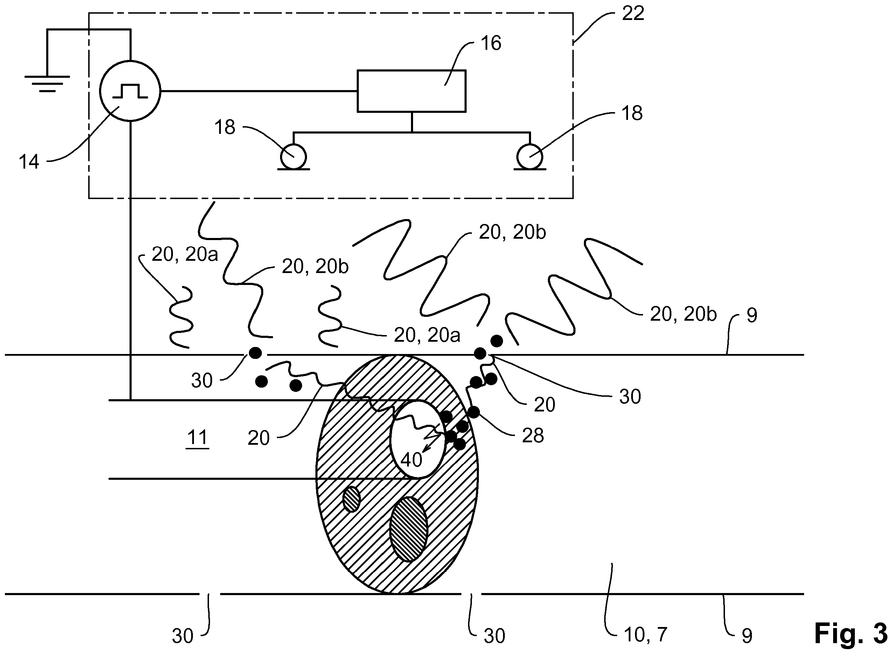

**Fig. 3** zeigt eine schematische Darstellung des zweiten erfindungsgemäßen Ortungssystems 22.

Das zweite Ortungssystem 22 umfasst wie das erste Ortungssystem 12 (Fig. 2) den Spannungsgenerator 14 zur Erzeugung einer elektrischen Spannung gegen Erde, mit der der elektrische Leiter 11 der Untermeeresversorgungsleitung 10 beaufschlagt ist, sowie die Auswerteeinrichtung 16 und die außerhalb der Förderplattform 8 angeordneten Schallsensoren 18.

In diesem Fall werden die infolge der Gasblasenbildung 28 in der Meerwasserfüllung 7 an dem Isolationsfehlerort 40 auf dem elektrischen Leiter 11 erzeugten und sich außerhalb der Untermeeresversorgungsleitung 10 ausbreitenden Schallwellen 20 mit Schallsensoren 18 erfasst. Die Schallsensoren 18 sind somit nicht unmittelbar an der äußeren Ummantelung 9 der Untermeeresversorgungsleitung 10 angebracht, sondern können an geeigneten Orten in einiger Entfernung von der Untermeeresversorgungsleitung 10 installiert sein. Bevorzugte Schallsensoren 18 wären beispielsweise Mikrobarometer mit ihrer hohen Empfindlichkeit.

Ist die äußere Ummantelung 9 der Untermeeresversorgungsleitung 10 mit Durchbohrungen 30 durchsetzt, - um den Auftrieb zu verringern und die Verlegung einfacher zu gestalten - werden nicht nur die mittelbar über Schwingungen der äußeren Ummantelung 9 übertragenen Schallwellen 20a, sondern auch die durch die Durchbohrungen 30 abgestrahlten Schallwellen 20b direkt erfasst.

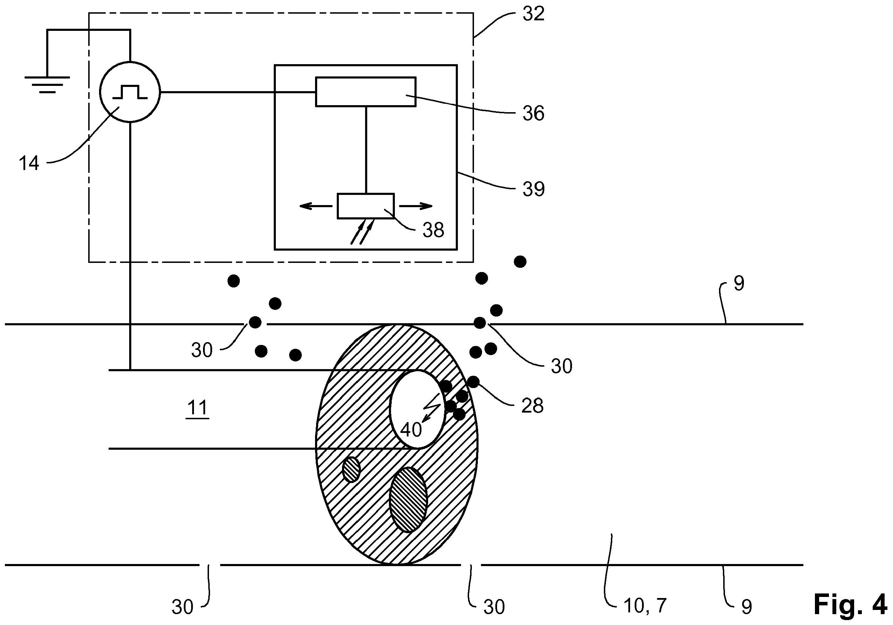

Die **Fig. 4** zeigt eine schematische Darstellung des dritten erfindungsgemäßen Ortungssystems 32.

Das dritte Ortungssystem 32 umfasst den Spannungsgenerator 14 zur Erzeugung einer elektrischen Spannung gegen Erde, mit der der elektrische Leiter 11 der Untermeeresversorgungsleitung 10 beaufschlagt ist, sowie eine Bildauswerteeinrichtung 36 und ein außerhalb der Förderplattform 8 angeordnetes Bilderfassungssystem 38.

Bei dem Einsatz dieses dritten Ortungssystems 32 wird von einer Untermeeresversorgungsleitung 10 ausgegangen, deren äußere Ummantelung 9 Durchbohrungen 30 aufweist und demzufolge mit Meerwasser 5 geflutet ist.

Zur Erfassung der durch die Durchbohrungen 30 austretenden Gasblasen 28 wird die unmittelbare Umgebung entlang der Untermeeresversorgungsleitung 10 mit einem beweglichen Bilderfassungssystem 38 optisch abgetastet (Scanning). Die erfassten Bildmuster werden im Hinblick auf eine Übereinstimmung mit typischen, durch die modulierte Spannungs-Impulsfolge eingeprägten Gasblasen-Bildmustern in der Bildauswerteeinrichtung 36 ausgewertet.

Das Bilderfassungssystem 38 und die Bildauswerteeinrichtung 36 können als integriertes, autonom navigierendes Bildverarbeitungssystem 39 ausgeführt sein, welches die Untermeeresversorgungsleitung 10 abtastet und prüft, ob erwartete Gasblasen-Bildmuster austreten.

Bei erkanntem Gasblasen-Bildmuster kann der diesem Gasblasen-Bildmuster zugehörige Erfassungsort als Isolationsfehlerort kommuniziert werden.

## Patentansprüche

1. Verfahren zum Bestimmen eines Isolationsfehlerortes (40) auf einem elektrischen Leiter (11) einer Untermeeresversorgungsleitung (10), welche mit Meerwasser (5) befüllbar ist, umfassend die Verfahrensschritte:
- Anlegen einer elektrischen Spannung gegen Erde an den elektrischen Leiter (11), wobei an dem Isolationsfehlerort (40) eine elektrochemische Reaktion zwischen einem metallischen Leitermaterial des elektrischen Leiters (11) und dem Meerwasser (5) eintritt, die eine Gaserzeugung bewirkt, und wobei die elektrische Spannung aus einer modulierten Spannungs-Impulsfolge gebildet wird und einen charakteristischen zeitlichen Verlauf aufweist, der sich in dem zeitlichen und räumlichen Verlauf von Schallwellen (20, 20c) widerspiegelt,
- Erfassen der Schallwellen (20, 20c) eines durch Gasblasenbildung (28) entstehenden Geräusches, wobei sich innerhalb der Untermeeresversorgungsleitung (10) in der Meerwasserfüllung (7) ausbreitende Schallwellen (20, 20c) des Geräusches mit Schallsensoren (18) erfasst werden, die an festgelegten Orten entlang der Untermeeresversorgungsleitung (10) installiert sind,
- Auswerten von Messsignal-Impulsfolgen, die von den Schallsensoren (18) geliefert werden, zur Bestimmung des Isolationsfehlerortes (40).

2. Verfahren nach Anspruch 1,
**dadurch gekennzeichnet,**
**dass** die Auswertung der Messsignal-Impulsfolgen durch Korrelationsberechungen der angelegten Spannungs-Impulsfolge mit den gemessenen Messsignal-Impulsfolgen erfolgt.

3. Verfahren zum Bestimmen eines Isolationsfehlerortes (40) auf einem elektrischen Leiter (11) einer Untermeeresversorgungsleitung (10), welche mit Meerwasser (5) befüllbar ist, umfassend die Verfahrensschritte:
- Anlegen einer elektrischen Spannung gegen Erde an den elektrischen Leiter (11), wobei an dem Isolationsfehlerort (40) eine elektrochemische Reaktion zwischen einem metallischen Leitermaterial des elektrischen Leiters (11) und dem Meerwasser (5) eintritt, die eine Gaserzeugung bewirkt, und wobei die elektrische Spannung aus einer modulierten Spannungs-Impulsfolge gebildet wird und einen charakteristischen zeitlichen Verlauf aufweist, der sich in dem zeitlichen und räumlichen Verlauf von Schallwellen (20, 20a, 20b) widerspiegelt,
- Erfassen der Schallwellen (20, 20a, 20b) eines durch Gasblasenbildung (28) entstehenden Geräusches, wobei Schallwellen (20, 20a, 20b) des Geräusches außerhalb der Untermeeresversorgungsleitung (10) mit Schallsensoren (18) erfasst werden, die an festgelegten Orten im Meerwasser (5) installiert sind,
- Auswerten von Messsignal-Impulsfolgen, die von den Schallsensoren (18) geliefert werden, zur Bestimmung des Isolationsfehlerortes (40).

4. Verfahren nach Anspruch 3,
**dadurch gekennzeichnet,**
**dass** die Auswertung der Messsignal-Impulsfolgen durch Korrelationsberechungen der angelegten Spannungs-Impulsfolge mit den gemessenen Messsignal-Impulsfolgen erfolgt.

5. Verfahren zum Bestimmen eines Isolationsfehlerortes (40) auf einem elektrischen Leiter (11) einer Untermeeresversorgungsleitung (10), welche eine äußere Ummantelung (9) mit Durchbohrungen (30) aufweist, umfassend die Verfahrensschritte:
- Anlegen einer elektrischen Spannung gegen Erde an den elektrischen Leiter (11), wobei an dem Isolationsfehlerort (40) eine elektrochemische Reaktion zwischen einem metallischen Leitermaterial des elektrischen Leiters (11) und dem Meerwasser (5) eintritt, die eine Gaserzeugung bewirkt, und wobei die elektrische Spannung aus einer modulierten Spannungs-Impulsfolge gebildet wird und einen charakteristischen zeitlichen Verlauf aufweist, durch den ein Gasblasen-Bildmuster eingeprägt wird,
- Erfassen von durch die Durchbohrungen (30) der äußeren Ummantelung (9) austretenden Gasblasen (28) durch optisches Abtasten einer unmittelbaren Umgebung entlang der Untermeeresversorgungsleitung (10) mit einem Bilderfassungssystem (38),
- Auswerten von Bildmustern zur Erkennung des eingeprägten Gasblasen-Bildmusters und zur Bestimmung des Isolationsfehlerortes (40).

6. Verfahren nach Anspruch 5,
**dadurch gekennzeichnet,**
**dass** die Auswertung der Bildmuster und die Erkennung der Gasblasen-Bildmuster durch Korrelationsberechungen der angelegten Spannungs-Impulsfolge mit einem erfassten Gasblasen-Bildmuster erfolgt.

7. Ortungssystem zum Bestimmen eines Isolationsfehlerortes (40) auf einem elektrischen Leiter (11) einer Untermeeresversorgungsleitung (10), welche mit Meerwasser (5) befüllbar ist,
mit einem Spannungsgenerator (14), der ausgebildet ist zum Erzeugen einer modulierten Spannungs-Impulsfolge, die einen charakteristischen zeitlichen Verlauf aufweist, der sich in dem zeitlichen und räumlichen Verlauf von Schallwellen (20, 20c) widerspiegelt, und die an den elektrischen Leiter (11) gegen Erde angelegt werden kann, mit Schallsensoren (18), die an festgelegten Orten entlang der Untermeeresversorgungsleitung (10) an dieser installierbar sind, um innerhalb der Untermeeresversorgungsleitung (10) in der Meerwasserfüllung (7) die sich ausbreitenden Schallwellen (20, 20c) zu erfassen, und mit einer Auswerteeinrichtung (16) zum Auswerten von Messsignal-Impulsfolgen, die von den Schallsensoren (18) geliefert werden, zur Bestimmung des Isolationsfehlerortes (40).

8. Ortungssystem zum Bestimmen eines Isolationsfehlerortes (40) auf einem elektrischen Leiter (11) einer Untermeeresversorgungsleitung (10), welche mit Meerwasser (5) befüllbar ist,
mit einem Spannungsgenerator (14), der ausgebildet ist zum Erzeugen einer modulierten Spannungs-Impulsfolge, die einen charakteristischen zeitlichen Verlauf aufweist, der sich in dem zeitlichen und räumlichen Verlauf von Schallwellen (20, 20a, 20b) widerspiegelt, und die an den elektrischen Leiter (11) gegen Erde angelegt werden kann, mit Schallsensoren (18),
die an festgelegten Orten in dem die Untermeeresversorgungsleitung (10) umgebenden Meerwasser (5) installierbar sind, um die von der Untermeeresversorgungsleitung (10) abgestrahlten Schallwellen (20, 20a, 20b) außerhalb der Untermeeresversorgungsleitung (10) zu erfassen, und mit einer Auswerteeinrichtung (16) zum Auswerten von Messsignal-Impulsfolgen, die von den Schallsensoren (18) geliefert werden, zur Bestimmung des Isolationsfehlerortes (40).

9. Ortungssystem zum Bestimmen eines Isolationsfehlerortes (40) auf einem elektrischen Leiter (11) einer Untermeeresversorgungsleitung (10), welche eine äußere Ummantelung (9) mit Durchbohrungen (30) aufweist,
mit einem Spannungsgenerator (14), der ausgebildet ist zum Erzeugen einer modulierten Spannungs-Impulsfolge, die einen charakteristischen zeitlichen Verlauf aufweist, durch den ein Gasblasen-Bildmuster eingeprägt wird, und die an den elektrischen Leiter (11) gegen Erde angelegt werden kann, nit einem Bilderfassungssystem (38), welches a dazu ausgebildet ist, an dem Isolationsfehlerort (40) entstehende und durch die Durchbohrungen (30) austretende Gasblasen (28) durch optisches Abtasten einer unmittelbaren Umgebung der Untermeeresversorgungsleitung (10) zu erfassen, und mit einer Bildauswerteeinrichtung (36) zum Auswerten von Bildmustern um das Gasblasen-Bildmuster zu erkennen und den Isolationsfehlerort (40) zu bestimmen.

10. Ortungssystem nach Anspruch 9,
**dadurch gekennzeichnet,**
**dass** das Bilderfassungssystem (38) und die Bildauswerteeinrichtung (36) als integriertes, autonom navigierendes Bildverarbeitungssystem (39) ausgeführt sind.

## Claims

1. A method for determining an insulation fault location (40) on an electric conductor (11) of a subsea supply line (10), which is filled with seawater (5), comprising the method steps:
- applying electric voltage to ground at the electric conductor (11), an electrochemical reaction taking place at the insulation fault location (40) between a metallic conductor material of the electric conductor (11) and the seawater (5), said electrochemical reaction forming gas, and said electric voltage being formed by a modulated voltage impulse sequence and having a characteristic temporal progression which is reflected in the temporal and spatial progression of sonic waves (20, 20c),
- capturing the sonic waves (20, 20c) of a noise made by formed gas bubbles (28), sonic waves (20, 20c) of the noise propagating within the subsea supply line (10) in the seawater filling (7) being captured using sonic sensors (18), which are installed at predetermined locations along the subsea supply line (10),
- evaluating measuring-signal impulse sequences supplied by the sonic sensors (18) in order to determine the insulation fault location (40).

2. The method according to claim 1,
**characterized in that**
the measuring-signal impulse sequences are evaluated by calculating a correlation of the applied voltage impulse sequence with the measured measuring-signal impulse sequences.

3. A method for determining an insulation fault location (40) on an electric conductor (11) of a subsea supply line (10), which is filled with seawater (5), comprising the method steps:
- applying electric voltage to ground at the electric conductor (11), an electrochemical reaction taking place at the insulation fault location (40) between a metallic conductor material of the electric conductor (11) and the seawater (5), said electrochemical reaction forming gas, and said electric voltage being formed by a modulated voltage impulse sequence and having a characteristic temporal progression which is reflected in the temporal and spatial progression of sonic waves (20, 20a, 20b),
- capturing the sonic waves (20, 20a, 20b) of a noise made by formed gas bubbles (28), sonic waves (20, 20a, 20b) of the noise being captured outside of the subsea supply line (10) using sonic sensors (18), which are installed at predetermined locations in the seawater (5),
- evaluating measuring-signal impulse sequences supplied by the sonic sensors (18) in order to determine the insulation fault location (40).

4. The method according to claim 3,
**characterized in that**
the measuring signal impulse sequences are evaluated by calculating a correlation of the applied voltage impulse sequence with the measured measuring-signal impulse sequences.

5. A method for determining an insulation fault location (40) on an electric conductor (11) of a subsea supply line (10), which comprises an outer casing (9) having through bores (30), comprising the method steps:
- applying electric voltage to ground at the electric conductor (11), an electrochemical reaction taking place at the insulation fault location (40) between a metallic conductor material of the electric conductor (11) and the seawater (5), said electrochemical reaction forming gas, said electric voltage being formed by a modulated voltage impulse sequence and having a characteristic temporal progression which impresses a gas-bubble image pattern,
- capturing gas bubbles (28) exiting from the through bores (30) of the outer casing (9) by optically sampling immediate surroundings along the subsea supply line (10) using an image capturing system (38),
- evaluating image patterns for identifying the imprinted gas-bubble image pattern and for determining the insulation fault location (40).

6. The method according to claim 5,
**characterized in that**
the image patterns are evaluated and the gas-bubble image patterns are identified by calculating a correlation of the applied voltage impulse sequence with a captured gas-bubble image pattern.

7. A locating system for determining an insulation fault location (40) on an electric conductor (11) of a subsea supply line (10), which is filled with seawater (5),
comprising a voltage generator (14) configured for generating a modulated voltage impulse sequence which has a characteristic temporal progression, which is reflected in the temporal and spatial progression of sonic waves (20, 20c), and is grounded to the electric conductor (11); the locating system comprising sonic sensors (18), which are installed at predetermined locations along the subsea supply line (10) in order to capture sonic waves (20, 20c) propagating within the subsea supply line (10) in the seawater filling (7); and the locating system comprising an evaluation device (16) for evaluating measuring-signal impulse sequences supplied by the sonic sensors (18) for determining the insulation fault location (40).

8. A locating system for determining an insulation fault location (40) on an electric conductor (11) of a subsea supply line (10), which is filled with seawater (5),
comprising a voltage generator (14) configured for generating a modulated voltage impulse sequence which has a characteristic temporal progression, which is reflected in the temporal and spatial progression of sonic waves (20, 20a, 20b), and is grounded to the electric conductor (11); the locating system comprising sonic sensors (18), which are installed at predetermined locations in the seawater (5) surrounding the subsea supply line (10) in order to capture sonic waves (20, 20a, 20b) emitted from the subsea supply line (10) outside of the subsea supply line (10); and the locating system comprising an evaluation device (16) for evaluating measuring-signal impulse sequences supplied by the sonic sensors (18) for determining the insulation fault location (40).

9. A tracking device for determining an insulation fault location (40) on an electric conductor (11) of a subsea supply line (10), which comprises an outer casing (9) having through bores (30),
the tracking device comprising a voltage generator (14) configured for generating a modulated voltage impulse sequence which has a characteristic temporal progression which imprints a gas-bubble image pattern, and is grounded to the electric conductor (11); the tracking device comprising an image capturing system (38) scon-figured for capturing gas bubbles (28) formed at the insulation fault location (40) and exiting from the through bores (30) by optically sampling immediate surroundings of the subsea supply line (10); and the tracking device comprising an image evaluation device (36) for evaluating image patterns in order to identify gas-bubble image patterns and to determine the insulation fault location (40).

10. The tracking device according to claim 9,
**characterized in that**
the image capturing system (38) and the image evaluation device (36) are configured as an integrated, autonomously navigating imaging system (39).

## Revendications

1. Procédé pour déterminer une localisation (40) d'un défaut d'isolement sur un conducteur électrique (11) d'une ligne d'alimentation sous-marine (10) qui est remplie de l'eau de mer (5), le procédé comprenant les étapes suivantes :
- appliquer une tension électrique à la terre au conducteur électrique (11), une réaction électrochimique se passant à la localisation (40) d'un défaut d'isolement entre un matériau conducteur métallique du conducteur électrique (11) et l'eau de mer (5), la réaction électrochimique formant du gaz, et la tension électrique étant produite par une séquence modulée d'impulsions de tension et ayant une propagation en espace temporel caractéristique qui se reflète dans la propagation en espace temporel et en espace des ondes sonores (20, 20c),
- capter les ondes sonores (20, 20c) d'un bruit fait par une formation des bulles de gaz (28), des ondes sonores (20, 20c) du bruit qui se propagent dans la ligne d'alimentation sous-marine (10) dans le remplissage d'eau de mer (7) étant captées en utilisant des capteurs soniques (18) qui sont installés à des endroits prédéterminés le long de la ligne d'alimentation sous-marine (10),
- évaluer des séquences d'impulsions de signal de mesure alimentées par les capteurs soniques (18) afin de déterminer la localisation (40) d'un défaut d'isolement.

2. Procédé selon la revendication 1,
**caractérisé en ce que**
les séquences d'impulsions de signal de mesure sont évaluées par le calcul d'une corrélation de la séquence appliquée d'impulsions de tension avec les séquences mesurées d'impulsions de signal de mesure.

3. Procédé pour déterminer une localisation (40) d'un défaut d'isolement sur un conducteur électrique (11) d'une ligne d'alimentation sous-marine (10) qui est remplie de l'eau de mer (5), le procédé comprenant les étapes suivantes :
- appliquer une tension électrique à la terre au conducteur électrique (11), une réaction électrochimique se passant à la localisation (40) d'un défaut d'isolement entre un matériau conducteur métallique du conducteur électrique (11) et l'eau de mer (5), la réaction électrochimique formant du gaz, et la tension électrique étant produite par une séquence modulée d'impulsions de tension et ayant une propagation en espace temporel caractéristique qui se reflète dans la propagation en espace temporel et en espace des ondes sonores (20, 20a, 20b),
- capter les ondes sonores (20, 20a, 20b) d'un bruit fait par une formation des bulles de gaz (28), des ondes sonores (20, 20a, 20b) du bruit étant captées en dehors de la ligne d'alimentation sous-marine (10) en utilisant des capteurs soniques (18) qui sont installés à des endroits prédéterminés dans l'eau de mer (5),
- évaluer des séquences d'impulsions de signal de mesure alimentées par les capteurs soniques (18) afin de déterminer la localisation (40) d'un défaut d'isolement.

4. Procédé selon la revendication 3,
**caractérisé en ce que**
les séquences d'impulsions de signal de mesure sont évaluées par le calcul d'une corrélation de la séquence appliquée d'impulsions de tension avec les séquences mesurées d'impulsions de signal de mesure.

5. Procédé pour déterminer une localisation (40) d'un défaut d'isolement sur un conducteur électrique (11) d'une ligne d'alimentation sous-marine (10) qui comprend une gaine extérieure (9) ayant des trous de passage (30), le procédé comprenant les étapes suivantes :
- appliquer une tension électrique à la terre au conducteur électrique (11), une réaction électrochimique se passant à la localisation (40) d'un défaut d'isolement entre un matériau conducteur métallique du conducteur électrique (11) et l'eau de mer (5), la réaction électrochimique formant du gaz, et la tension électrique étant produite par une séquence modulée d'impulsions de tension et ayant une propagation en espace temporel caractéristique qui impressionne un modèle d'image de bulles de gaz,
- capter des bulles de gaz (28) sortant des trous de passage (30) de la gaine extérieure (9) par l'échantillonnage optique d'un environnement immédiat le long de la ligne d'alimentation sous-marine (10) en utilisant un système de saisie d'image (38),
- évaluer des patrons d'image pour identifier le patron d'image de bulles de gaz et pour déterminer la localisation (40) d'un défaut d'isolement.

6. Procédé selon la revendication 5,
**caractérisé en ce que**
les patrons d'image sont évalués et les patrons d'image de bulles de gaz sont identifiés par le calcul d'une corrélation de la séquence appliquée d'impulsions de tension avec un patron capté d'image de bulles de gaz.

7. Système de localisation pour déterminer une localisation (40) d'un défaut d'isolement sur un conducteur électrique (11) d'une ligne d'alimentation sous-marine (10) qui est remplie de l'eau de mer (5),
comprenant un générateur de tension (14) configuré pour générer une séquence modulée d'impulsions de tension qui a une propagation en espace temporel caractéristique, qui se reflète dans la propagation en espace temporel et en espace des ondes sonores (20, 20c), et est mise à la terre au conducteur électrique (11); le système de localisation comprenant des capteurs soniques (18) qui sont installés à des endroits prédéterminés le long de et sur la ligne d'alimentation sous-marine (10) afin de capter dans la ligne d'alimentation sous-marine (10) dans le remplissage d'eau de mer (7) des ondes sonores (20, 20c) qui se propagent; et le système de localisation comprenant un dispositif d'évaluation (16) pour évaluer des séquences d'impulsions de signal de mesure alimentées par les capteurs soniques (18) pour déterminant la localisation (40) d'un défaut d'isolement.

8. Système de localisation pour déterminer une localisation (40) d'un défaut d'isolement sur un conducteur électrique (11) d'une ligne d'alimentation sous-marine (10) qui est remplie de l'eau de mer (5),
le système de localisation comprenant un générateur de tension (14) configuré pour générer une séquence modulée d'impulsions de tension qui a une propagation en espace temporel caractéristique, qui se reflète dans la propagation en espace temporel et en espace des ondes sonores (20, 20a, 20b), et est mise à la terre au conducteur électrique (11); le système de localisation comprenant des capteurs soniques (18) qui sont installés à des endroits prédéterminés dans l'eau de mer (5) entourant la ligne d'alimentation sous-marine (10) afin de capter des ondes sonores (20, 20a, 20b) émisses par la ligne d'alimentation sous-marine (10) en dehors de la ligne d'alimentation sous-marine (10); et le système de localisation comprenant un dispositif d'évaluation (16) pour évaluer des séquences d'impulsions de signal de mesure alimentées par les capteurs soniques (18) pour déterminer la localisation (40) d'un défaut d'isolement.

9. Système de repérage pour déterminer une localisation (40) d'un défaut d'isolement sur un conducteur électrique (11) d'une ligne d'alimentation sous-marine (10) qui comprend une gaine extérieure (9) ayant des trous de passage (30),
le système de repérage comprenant un générateur de tension (14) configuré pour générer une séquence modulée d'impulsions de tension qui a une propagation en espace temporel caractéristique qui impressionne un patron d'image de bulles de gaz, et est mise à la terre au conducteur électrique (11); le système de repérage comprenant un système de saisie d'image (38) configuré pour saisir des bulles de gaz (28) formées à la localisation (40) d'un défaut d'isolement et sortant des trous de passage (30) par l'échantillonnage optique d'un environnement immédiat de la ligne d'alimentation sous-marine (10); et le système de repérage comprenant un dispositif d'évaluation d'image (36) pour évaluer des patrons d'image afin d'identifier le patron d'image de bulles de gaz et pour déterminer la localisation (40) d'un défaut d'isolement.

10. Système de repérage selon la revendication 9,
**caractérisé en ce que**
le système de saisie d'image (38) et le dispositif d'évaluation d'image (36) sont configurés comme système de traitement d'image (39) intégré qui navigue autonomement.
